## Europäisches Patentamt

## European Patent Office

## Office européen des brevets

(11) Veröffentlichungsnummer: **0 033 920**
**B1**

(12) **EUROPÄISCHE PATENTSCHRIFT**

(45) Veröffentlichungstag der Patentschrift:
22.08.84

(21) Anmeldenummer: **81100696.4**

(22) Anmeldetag: **31.01.81**

(51) Int. Cl.³: **H 03 D 7/12,** H 04 B 1/28,
H 03 F 3/193, H 04 N 5/50

(54) Mischerschaltung für einen UHF/VHF-Tuner mit einem Dual-Gate-MOS-Feldeffekttransistor.

(30) Priorität: **06.02.80 DE 3004205**

(43) Veröffentlichungstag der Anmeldung:
**19.08.81 Patentblatt 81/33**

(45) Bekanntmachung des Hinweises auf die Patenterteilung:
**22.08.84 Patentblatt 84/34**

(84) Benannte Vertragsstaaten:
**AT FR GB**

(56) Entgegenhaltungen:
**DE - A - 2 728 710**
**DE - A - 2 728 760**
**DE - A - 2 846 411**
**DE - B - 1 566 974**
**DE - B - 2 624 133**
**US - A - 3 727 140**
**US - A - 3 976 944**

**Patents Abstracts of Japan Band 3, Nr. 98, 18. August 1979 Seite 44E131**
**Patents Abstracts of Japan Band 2, Nr. 102, 23. August 1978 Seite 5316E78**
**"FUNK-TECHNIK" 1976, Heft 3, Seite 52 bis 54**

(73) Patentinhaber: **International Standard Electric Corporation, 320 Park Avenue, New York New York 10022 (US)**

(72) Erfinder: **Schurig, Kurt, Wagnerstrasse 10, D-7531 Eisingen (DE)**

(74) Vertreter: **Graf, Georg Hugo, Dipl.-Ing. et al, c/o Standard Elektrik Lorenz AG Patent- und Lizenzwesen Postfach 300 929 Kurze Strasse 8, D-7000 Stuttgart 30 (DE)**

**Beschreibung**

Die Erfindung betrifft eine im Oberbegriff des Anspruches 1 angegebene Mischerschaltung für einen UHF/VHF-Tuner.

Ein UHF/VHF-Tuner mit einer derartigen Mischerschaltung ist aus der Zeitschrift «Funk-Technik» 1976, Heft 3, Seite 52 bis 54 bekannt. Die VHF-Mischerschaltung des bekannten Tuners enthält einen Dual-GATE-MOS-Feldeffekttransistor (im folgenden mit Dual-MOS-FET bezeichnet), der im VHF-Betrieb des Tuners als Mischtransistor und im UHF-Betrieb des Tuners als UHF-ZF-Nachverstärker arbeitet und an dessen Drain-Anschluss die ZF-Spannung abgenommen wird. Im UHF-Betrieb ist der VHF-Mischoszillator durch eine nur bei UHF-Betrieb angelegte Betriebs- und Schaltspannung über eine Schaltdiode ausgeschaltet und eine selbstschwingende UHF-Mischstufe eingeschaltet und über einen Spannungsteiler eine Vorspannung zur Einstellung eines erforderlichen Arbeitspunktes an das erste Gate des Dual-MOS-FET gelegt. Ausserdem gelangt über eine von der UHF-Betriebsspannung durchlässig gesteuerte Schaltdiode die UHF-ZF-Spannung vom Ausgang der UHF-Mischstufe an das erste Gate des Dual-MOS-FET. Bei VHF-Betrieb ist der Ausgang des nunmehr eingeschalteten VHF-Mischoszillators an das nunmehr über einen Widerstand des Spannungsleiters an Masse gelegte erste Gate des Dual-MOS-FET angekoppelt, an das zur additiven Mischung auch der Ausgang des VHF-Bandfilters angekoppelt ist.

Die additive Mischerschaltung mit einem Dual-MOS-FET hat den Vorzug hoher Mischverstärkung und guten Kreuzmodulationsverhaltens. Ausserdem hat sie den Vorzug, dass die optimalen Arbeitspunkte des Dual-MOS-FET für VHF- und für UHF-ZF-Betrieb annähernd gleich sind. Mit einer multiplikativen Mischung in der VHF-Mischstufe mit einem Dual-Gate-MOS-FET lässt sich jedoch insbesondere eine geringere Oszillatorstörstrahlung an der Antennenbuchse erreichen.

Der Erfindung liegt die Aufgabe zugrunde, einen UHF/VHF-Tuner der eingangs angegebenen Art so auszubilden, dass bei Verwendung einer multiplikativen VHF-Mischstufe der Arbeitspunkt des MOS-FET so verändert wird, dass sowohl im VHF-Bereich eine optimale Mischverstärkung, als auch im UHF-Bereich eine sehr gute ZF-Nachverstärkung erreicht wird.

Diese Aufgabe ist erfindungsgemäss durch die im Anspruch 1 angegebenen Merkmale gelöst.

Weitere Ausgestaltungen der Erfindung sind aus den Unteransprüchen zu ersehen.

Die Erfindung hat insbesondere den Vorteil, dass die erfindungsgemässe Schaltung eine multiplikative Mischung unter Verwendung von MOS-FETS über einen sehr grossen Frequenzbereich mit grosser Kreuzmodulationsfestigkeit und geringer Oszillatorstörleistung ergibt. Dadurch wird es möglich, einen mit Dual-Gate-MOS-FETs aufgebauten UHF/VHF-Tuner zu schaffen, bei dem eine gleichgrosse Verstärkung für die VHF- und -UHF-Bereiche erfolgt und der Tuner in zwei grossen Bereichen von vorzugsweise 45 MHz bis 290 MHz durchstimmbar ist, unter Verwendung von Kapazitätsdioden.

Weiterhin ergibt sich durch das Umschalten des Arbeitspunktes des MOS-FET eine einfache Schaltung für die UHF-ZF-Nachverstärkung. Die Erfindung ist sowohl für Kabel-Tuner als auch für CCIR-Tuner anwendbar.

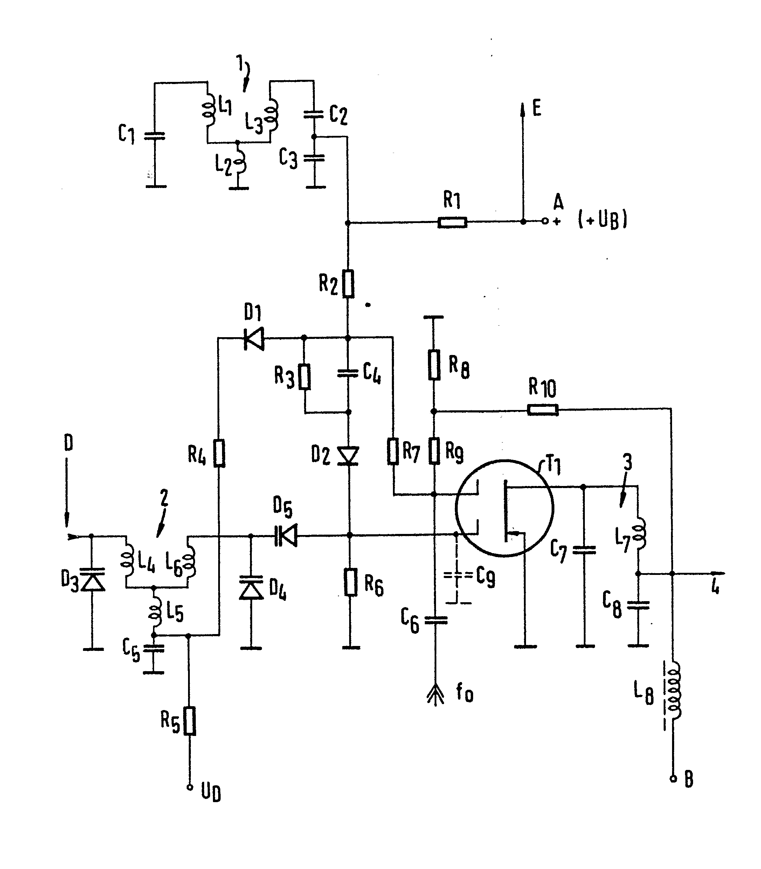

Die Erfindung ist nachfolgend anhand eines Ausführungsbeispiels, welches in der Zeichnung dargestellt ist, näher erläutert.

Die Zeichnung zeigt eine erfindungsgemässe VHF-Mischerschaltung in schematischer Darstellung.

Mit 1 ist ein UHF-ZF-Bandfilter bezeichnet. Es besteht aus einer Kapazität $C_1$, Induktivitäten $L_1$, $L_2$, $L_3$ und Kapazitäten $C_2$ und $C_3$. 2 ist ein abstimmbares Bandfilter (VHF-HF-Bandfilter) und umfasst beispielsweise den Bereich von 105 bis 290 MHz. Der Eingang D bezeichnet den Anschluss von der VHF-Vorstufe. Das Bandfilter 2 besteht aus einer Kapazitätsdiode $D_3$, Induktivitäten $L_4$, $L_5$, $L_6$ und einer Kapazität $C_5$, sowie aus weiteren Kapazitätsdioden $D_4$ und $D_5$.

Auf diesen Schaltungsteil folgt ein Dual-Gate-MOSE-FET $T_1$ sowie ein eine kapazitive Fusspunkt-Auskopplung aufweisender ZF-Kreis 3, bestehend aus einer Kapazität $C_7$, einer Induktivität $L_7$ und einer Kapazität $C_8$. Der ZF-Ausgang ist mit 4 bezeichnet. Die Spannungsversorgung des MOS-FETS $T_1$ erfolgt von der Spannungsquelle B über die Drossel $L_8$. Das Umschaltnetzwerk besteht aus den Widerständen $R_4$ und $R_5$, einer Diode $D_1$, weiteren Widerständen $R_1$, $R_2$, $R_3$, einem Kondensator $C_4$, einer (weiteren) Diode $D_2$ und (weiteren) Widerständen $R_6$, $R_7$, $R_8$, $R_9$, $R_{10}$. Ein Kondensator $C_6$ dient zur Ankopplung der VHF-Oszillatorspannung fo (nur bei VHF-Betrieb) an das Gate 2 des MOS-FET $T_1$.

Im folgenden ist die Arbeits- und Wirkungsweise der erfindungsgemässen Schaltung beschrieben.

Bei VHF-Betrieb arbeitet der Transistor $T_1$ in multiplikativer Mischung, d.h. die Oszillatorspannung wird über $C_6$ an Gate 2 von $T_1$ geführt, die Eingangsspannung des oben beschriebenen HF-Bandfilters über $D_5$ an das Gate 1 gelegt und die ZF wird schliesslich über den Drainanschluss von $T_1$ über den ZF-Kreis 3 ausgekoppelt zur weiteren Verstärkung im ZF-Verstärker. Am Schaltungspunkt A liegt in diesem Falle keine Betriebsspannung und kein Widerstand nach Masse, so dass Gate 1 über $R_6$ an Masse liegt und somit tritt keine Spannungsdifferenz zwischen Gate 1 und source auf. Gate 2 dagegen erhält über den aus den Widerständen $R_{10}$, $R_8$ gebildeten Spannungsteiler und den Entkopplungswiderstand $R_9$ eine positive Spannung von z.B. ca. 0,25 V. Dies ist der optimale Arbeitspunkt für die multiplikative VHF-Mischschaltung. Die positive Abstimmspannung $U_D$ (z.B. + 1V bis + 30V) gelangt über $R_5$ an die Abstimmdioden $D_3$, $D_4$ und die Kapazitäts- bzw. Koppeldiode $D_5$, ausserdem über $R_4$ an die Diode

D$_1$, die sich in Sperrichtung befindet, da ihre Anode über R$_3$ und R$_7$ von Gate 2 her eine geringe Spannung von z.B. nur 0,25 V erhält. Die Diode D$_2$ erhält ebenfalls über R$_7$ nur 0,25 V an der Anode, während die Kathode über R$_6$ an Masse liegt. Daher ist diese Diode gesperrt.

Bei UHF-Betrieb dagegen ist der VHF-Oszillator abgeschaltet und über das VHF-HF-Bandfilter und die Koppeldiode D$_5$ gelangt auch keine VHF-Eingangsspannung an das Gate 1, da die VHF-Vorstufe ebenfalls ausser Betrieb ist. Jetzt gelangt aber eine positive Betriebsspannung U$_B$ (z.B. ca. 12 V) (der Pfeil E gibt die Betriebsspannung zum UHF-Tuner an) vom Schaltungspunkt A über R$_1$, R$_2$, R$_3$ an D$_2$, diese wird geöffnet, so das die UHF-ZF-Spannung über R$_2$, C$_4$, D$_2$ an das Gate 1 gelangt, das nun eine kleine positive Vorspannung von z.B. ca. 0,5 V gegenüber source erhält. Über R$_7$, R$_9$ und R$_8$ erhält Gate 2 z.B. ca. +4 V und dadurch wird der optimale Arbeitspunkt für eine UHF-ZF-Nachverstärkung erreicht.

Um eine kapazitive Belastung des UHF-ZF-Bandfilters am Gate 1 durch die Kapazitätsdioden D$_4$ und D$_5$ vernachlässigbar klein zu halten, wird die UHF-Betriebsspannung von A über R$_1$, R$_2$ über die Diode D$_1$, R$_4$ an die Abstimmdioden D$_4$ und D$_5$ geführt. Diese sind dann mit z.B. ca. 11,4 V gesperrt. Sobald die Abstimmspannung U$_D$ grössere Werte als 11,4 V annimmt, bis z.B. ca. 30 V, verändert sich die Kapazität der in Sperrichtung betriebenen Abstimmdioden nur noch geringfügig, so dass eine Verstimmung des UHF-ZF-Bandfilters vernachlässigbar ist.

Die Kapazitätsdiode D$_5$ ist bei Kabel-Tunern mit nur zwei grossen Abstimmbereichen erforderlich, um eine feste Ankopplung des Gate 1 an den Sekundärkreis des VHF-Bandfilters bei tiefen Abstimmfrequenzen zu erreichen. Dagegen verringert diese Diode D$_5$ bei hohen Abstimmfrequenzen die Eingangskapazität C$_9$ des Gate 1, da D$_5$ mit C$_9$ in Reihe liegt.

Bei VHF-Tunern mit den eingeschränkten Frequenzbereichen nach CCIR (E$_2$ bis E$_4$ und E$_5$ bis E$_{12}$) ist nur eine Festkapazität von z.B. ca 4pF anstelle von D$_5$ erforderlich; dann entfallen die Bauteile R$_4$ und D$_1$.

## Patentansprüche

1. Mischerschaltung für einen UHF/VHF-Tuner mit einem Dual-MOS-Feldeffekttransistor (T$_1$), der im VHF-Betrieb des Tuners als Mischertransistor und im UHF-Betrieb des Tuners als UHF-ZF-Verstärker betrieben wird und dessen eines Gate, dem die VHF- bzw. UHF-Spannung zugeführt wird, im UHF-Betrieb des Tuners an den Abgriff eines zwischen einer im UHF-Betrieb eingeschalteten Schaltspannung (+U$_B$ an Anschluss A) und Masse angeordneten Spannungsteilers (R$_1$, R$_2$, R$_3$, R$_6$) angeschlossen ist und dessen zweites Gate an einer festen Vorspannung liegt, dadurch gekennzeichnet,

– dass das zweite Gate des Dual-MOS-Feldeffekttransistors (T$_1$) an einen Abgriff eines zweiten Spannungsteilers (R$_7$, R$_9$) angeschlossen ist, der zwischen einem Abgriff des zwischen dem ersten Gate und dem Anschluss (A) für die Schaltspannung (+U$_B$) liegenden Teils (R$_1$, R$_2$, R$_3$) des ersten Spannungsteilers (R$_1$, R$_2$, R$_3$, R$_6$) und der Vorspannungsquelle (Spannungsteiler) (R$_8$, R$_{10}$) für das zweite Gate angeschlossen ist,

– dass die feste Vorspannung der Vorspannungsquelle (Spannungsteiler R$_8$, R$_{10}$) für das zweite Gate so bemessen ist, dass im VHF-Betrieb am Dual-MOS-Feldeffekttransistor (T$_1$) ein optimaler Arbeitspunkt für die multiplikative VHF-Mischschaltung eingestellt ist,

– dass in dem zwischen dem ersten Gate und der Schaltspannung liegenden Teil des ersten Spannungsteilers eine Schaltdiode (D$_2$) angeordnet ist, die im UHF-Betrieb des Tuners bei Anliegen der Schaltspannung (+U$_B$) leitend gesteuert ist,

– dass der zwischen den beiden Gates liegende Widerstand (R$_3$) des ersten Spannungsteilers kapazitiv überbrückt ist,

– und dass bei der UHF-Betrieb die UHF-ZF-Spannung in den zwischen der Schaltdiode (D$_2$) und der Schaltspannung (+U$_B$) liegenden Teil (R$_1$, R$_2$, R$_3$) des ersten Spannungsteilers (R$_1$, R$_2$, R$_3$, R$_6$) eingespeist ist.

2. Mischerschaltung nach Anspruch 1, dadurch gekennzeichnet, dass ein dem ersten Gate des Dual-MOS-Feldeffekttransistor (T$_1$) vorgeschaltetes, mittels Kapazitätsdioden (D$_3$, D$_4$) abstimmbares VHF-Bandfilter (2) über eine Kapazitätsdiode (D$_5$) an das erste Gate angekoppelt ist.

3. Mischerschaltung nach Anspruch 2, dadurch gekennzeichnet, dass zwischen die der Abstimmspannung (U$_D$) zunächstliegenden Elektroden der Kapazitätsdioden (D$_3$, D$_4$, D$_5$) und einen Abgriff des ersten Spannungsteilers (R$_1$, R$_2$, R$_3$, R$_6$) die Reihenschaltung aus einer Schaltdiode (D$_1$) und einem Widerstand (R$_4$) geschaltet ist, die derart ausgebildet ist, dass die Schaltdiode bei am Anschluss (A) angelegter Schaltspannung (U$_B$) leitend ist und die Kapazitätsdioden auf einen am niederkapazitiven Ende ihrer Kennlinie liegenden Kapazitätswert steuert.

## Claims

1. Mixer circuit for a UHF/VHF tuner with a dual MOS field effect transistor (T$_1$) which is operated as a mixer transistor in VHF operation of the tuner and as a UHF IF amplifier in UHF operation of the tuner and of which one gate, to which the VHF or UHF voltage is applied, is connected in UHF operation of the tuner to the tap of a voltage divider (R$_1$, R$_2$, R$_3$, R$_6$) situated between a switching voltage switched on in UHF operation (+U$_B$ at terminal A) and earth and of which the second gate is connected to a fixed bias voltage, characterised in this,

– that the second gate of the dual MOS field effect transistor (T$_1$) is connected to a tapping of a second voltage divider (R$_7$, R$_9$) which is connected between a tapping of the part (R$_1$, R$_2$, R$_3$) of the first voltage divider (R$_1$, R$_2$, R$_3$, R$_6$) situated be-

tween the first gate and the terminal (A) for the switching voltage (+$U_B$) and the bias voltage source (voltage divider $R_8$, $R_{10}$) for the second gate,
— that the fixed bias voltage of the bias voltage source (voltage divider $R_8$, $R_{10}$) for the second gate is so dimensioned that in VHF operation an optimum operating point for the multiplying VHF mixer circuit is set on the dual MOS field effect transistor ($T_1$),
— that in the part of the first voltage divider situated between the first gate and the switching voltage there is a switching diode ($D_2$) which is made conductive in UHF operation of the tuner when the switching voltage (+$U_B$) is applied.
— that the resistor ($R_3$) of the first voltage divider situated between the two gates is capacitively bridged,
— and that in UHF operation the UHF IF voltage is fed into the part ($R_1$, $R_2$, $R_3$) of the first voltage divider ($R_1$, $R_2$, $R_3$, $R_6$) situated between the switching diode ($D_2$) and the switching voltage (+$U_B$).

2. Mixer circuit according to Claim 1, characterised in this, that a VHF band-pass filter (2) tunable by means of tuning diodes ($D_3$, $D_4$), connected in front of the first gate of the dual MOS field effect transistor ($T_1$), is coupled to the first gate via a tuning diode ($D_5$).

3. Mixer circuit according to Claim 2, characterised in this, that the series circuit consisting of a switching diode ($D_1$) and a resistor ($R_4$) is interposed between the electrodes closest to the tuning voltage ($U_D$) of the tuning diodes ($D_3$, $D_4$, $D_5$) and a tapping of the first voltage divider, the said series circuit being such that, when switching voltage ($U_B$) is applied to terminal (A), the switching diode is conductive and drives the tuning diodes to a capacitance value at the low-capacitance end of their characteristic.

**Revendications**

1. Circuit mélangeur pour tuner UHF/VHF, comportant un transistor à effet de champ ($T_1$) à deux grilles, de type MOS, qui, lors de l'utilisation de tuner en VHF, opère en transistor mélangeur et, lors de l'utilisation du tuner en UHF, opère en amplificateur UHF-FI, et dont la première grille, celle recevant la tension VHF ou UHF selon le cas, est, lors de l'utilisation du tuner en UHF, raccordée à la prise d'un diviseur de tension ($R_1$, $R_2$, $R_3$, $R_6$) disposé entre une tension de commutation (+$U_B$ à la borne A) appliquée lors de l'utilisation en UHF, et la masse, la deuxième grille étant reliée à une tension de polarisation fixe, caractérisé en ce que:

— la deuxième grille du transistor MOS à effet de champ ($T_1$), à deux grilles, est reliée à une prise d'un deuxième diviseur de tension ($R_7$, $R_9$) qui est branché entre, d'une part, une prise de la partie ($R_1$, $R_2$, $R_3$) du premier diviseur de tension ($R_1$, $R_2$, $R_3$, $R_6$) située entre la première grille et la borne (A) d'application de la tension de commutation (+$U_B$) et, d'autre part, la source de tension de polarisation (diviseur de tension $R_8$, $R_{10}$) pour la deuxième grille.
— la tension de polarisation fixe de la source de tension de polarisation (diviseur de tension $R_8$, $R_{10}$) pour la deuxième grille est dimensionnée de façon que, lors de l'utilisation en VHF, un point de fonctionnement optimal pour le circuit mélangeur VHF multiplicatif soit établi au transistor MOS à effet de champ ($T_1$) à deux grilles,
— dans la partie du premier diviseur de tension située entre la première grille et la tension de commutation, il y a une diode de commutation ($D_2$) qui, lors de l'utilisation du tuner en UHF, est commandée de façon à être mise en conduction par l'application de la tension de commutation (+$U_B$),
— la résistance ($R_3$) du premier diviseur de tension située entre les deux grilles est shuntée capacitivement,
— et, lors de l'utilisation en UHF, la tension UHF-FI est injectée dans la partie ($R_1$, $R_2$, $R_3$) du premier diviseur de tension ($R_1$, $R_2$, $R_3$, $R_6$) située entre la diode de commutation ($D_2$) et la tension de commutation (+$U_B$).

2. Circuit mélangeur selon la revendication 1, caractérisé en ce qu'un filtre de bande VHF (2), accordable au moyen de diodes capacitives ($D_3$, $D_4$), branché en amont de la première grille du transistor MOS ($T_1$) à effet de champ, à deux grilles, est couplé à la première grille par l'intermédiaire d'une diode à capacité variable ($D_5$).

3. Circuit mélangeur selon la revendication 2, caracterisé en ce qu'un dipôle série constitué par une diode de commutation ($D_1$) et une résistance ($R_4$) est branché entre une prise du premier diviseur de tension ($R_1$, $R_2$, $R_3$, $R_6$) et celles des électrodes des diodes à capacité variable ($D_3$, $D_4$, $D_5$) qui sont les plus proches de la tension d'accord ($U_D$), de dipôle série étant constitué de façon que sa diode de commutation soit conductrice en cas d'application d'une tension de commutation ($U_B$) à ladite borne (A), et commande les diodes à capacité variable de façon à les mettre à leur capacité la plus faible, située à l'extrémité de leur courbe caractéristique.